Europäisches Patentamt

European Patent Office

Office européen des brevets

(19)

(11) Publication number: 0 449 226 A1

# EUROPEAN PATENT APPLICATION

(21) Application number: 91104803.1

(22) Date of filing: 26.03.91

(51) Int. Cl.5: H01L 45/00, C09D 5/44, G02F 1/136

(30) Priority: 27.03.90 JP 78509/90

(43) Date of publication of application:
02.10.91 Bulletin 91/40

(84) Designated Contracting States:
CH DE FR GB LI NL

(71) Applicant: SEIKO EPSON CORPORATION
4-1, Nishishinjuku 2-chome
Shinjuku-ku Tokyo-to(JP)

(72) Inventor: Ono, Yoshihiro
c/o Seiko Epson Corporation, 3-5, Owa
3-chome
Suwa-shi, Nagano-ken(JP)
Inventor: Matsushima, Fumiaki
c/o Seiko Epson Corporation, 3-5, Owa
3-chome
Suwa-shi, Nagano-ken(JP)
Inventor: Matsui, Kuniyasu
c/o Seiko Epson Corporation, 3-5, Owa
3-chome
Suwa-shi, Nagano-ken(JP)
Inventor: Tetsuji, Osaka
2-4, Shibakubo 29-chome
Tanashi-shi, Tokyo-to(JP)

(74) Representative: Blumbach Weser Bergen
Kramer Zwirner Hoffmann Patentanwälte
Radeckestrasse 43
W-8000 München 60(DE)

(54) Non-linear resistor switching element, active matrix liquid crystal panel using the same, and method for manufacturing the non-linear resistor switching element.

(57) Disclosed is a non-linear resistor switching element comprising on a substrate (1) a first conductor, on the first conductor (2) an insulator (3) and on the insulator a second conductor (4). The insulator (3) is a highly insulating organic electrolytic polymer film formed by an organic material which is electrolytically polymerized in an alkali hydroxide solution, or a basic alcohol solution containing alkali hydroxide as an supporting electrolyte. An active matrix type liquid crystal display panel using these non-linear resistor switching elements instead of conventional MIM elements exhibits a better contrast and is easier to manufacture.

Fig. 1 (a)

Fig. 1 (b)

Fig. 1 (c)

Fig. 1 (d)

The image display methods of liquid crystal television screens at present may be classified broadly into a simple matrix method and an active matrix method. The simple matrix method includes a liquid crystal interposed between two opposed, perpendicularly-intersecting sets of multiple strip electrodes, which are respectively connected to driving circuits. Since this structure is simple, this system can be attained at a low cost but involves the problem of low contrast due to crosstalk. As compared with the simple matrix method, in the active matrix method a switch is provided for each picture element to maintain a voltage written into the picture element. Since the selected voltage can be maintained even in time divisional driving, the display capacity can be increased and the property of the image quality such as contrast is satisfactory, but the structure is complicated and the manufacturing cost is higher. For instance, with TFT switches (Thin Film Transistor), it is difficult to improve the yield because five or six layered thin films are disposed by using five or more photomasks. In view of the above, two-terminal devices have been used as active switch devices since they can be manufactured with better yield and low cost. A typical two-terminal device is an MIM (Metal Insulator Metal) device.

Conventionally TaOx prepared by anodizing a lower electrode has been used as the insulating film in MIM devices. However, since the dielectric constant thereof is about 26, the capacitance of the MIM device is as high as 0.1 pF, which is as much as more than 1/3 of the liquid crystal capacitance per general picture element (200 $\mu$m x 200 $\mu$m), under general conditions of a MIM device of a size of 5 $\mu$m x 4 $\mu$m and an anodic oxidation film of a thickness of 60 nm.

However, since the capacitance ratio of the liquid crystal picture element to the active MIM device is about three upon applying a voltage to the liquid crystal panel, this involves the problem that no sufficient voltage is applied to the MIM device to worsen its switching characteristic and consequently, the quality of panel display is inferior to that of a TFT panel.

Accordingly, an organic insulating film formed by the organic electrolytic polymerization process has been used as insulator of a MIM device in order to improve the switching characteristic (Japanese patent appln. No. 85374/89). Generally, its dielectric constant is not more than 10, which is a sufficiently low value to improve the characteristic. In the process of forming the organic insulating film, an undoping treatment is necessary after forming the organic film by using the organic electrolytic polymerization, in order to obtain an insulating film. However, there are the following problems. It is difficult to remove the dopant ions completely and it is also difficult to obtain a reproducible characteristic because the undoping treatment has an influence upon the surface of the films. Besides, the process of forming the switching element is complicated.

According to the conventional method for manufacturing an MIM device, an organic film is formed by an electrolytic polymerization process, and is then electrochemically undoped, whereby an insulating film is obtained. However, with such method, it is difficult to obtain a reproducible characteristic because dopant ions cannot be removed completely and the film surface is affected. Besides, though a bidirectional non-linear characteristic is necessary for a non-linear resistor switching element, the characteristic suffers from a difference depending on the polarity.

This invention is to eliminate the defect of the prior art and it is an object of this invention to provide a non-linear resistor switching element having an insulating film which is electrochemically inactive without requiring an undoping treatment and has stable polarity-independent electrical characteristics. It is another object of this invention to provide a method for manufacturing such a non-linear resistor switching element and an active matrix liquid crystal panel using it.

These objects are achieved with a non-linear resistor switching element, an active matrix type liquid crystal panel using the same, and a method for manufacturing the non-linear resistor switching element as claimed.

As will be shown in the following examples, an undoping treatment, which had to be carried out in the prior art after forming an organic film by electrolytic polymerization is not necessary with the invention, so that the manufacturing method is simplified. Further, the switching element has a smoother surface and a stabler characteristic as compared with the conventional MIM elements which have been undoped. It is found that the active matrix liquid crystal panel using the non-linear resistor switching elements produced by the procedure of this invention has an improved contrast. Furthermore, the following great advantage is confirmed, namely the area of the switching element can be set larger than that of the conventional elements retaining a good switching performance, whereby the preparation of the element is facilitated.

Embodiments of the invention will be described below with reference to the drawings, in which:

Fig. 1(a) - (d)  are a cross sectional views to illustrate the process for forming a non-linear resistor switching element according to the invention.

Fig. 2  shows characteristics of the non-linear resistor switching element of Example 2.

Fig. 3   is a structural drawing of an element of an active matrix type liquid crystal panel using the non-linear resistor switching element of the invention.

Fig. 4   is a partial cross sectional view of an active matrix type liquid crystal panel using the non-linear resistor switching element of the invention.

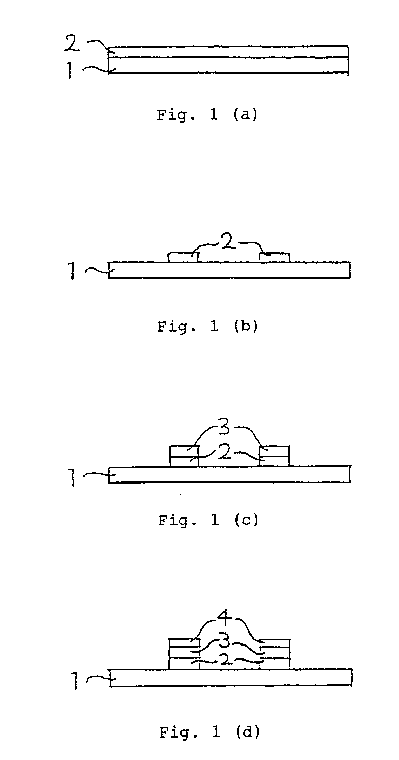

Referring to Fig. 1 a method according to the invention will be described first.

A conductor 2 is formed on a transparent substrate 1 (Fig. 1(a)) and may be a transparent conductive film of Au, Ag, Cu, Ni, Cr, Ta, $In_2O_3$, $SnO_2$, ITO (Indium Tin Oxide), or the like. The conductor may also be a semiconductor. As the film forming method, sputtering, vacuum deposition, CVD, plating, or the like is used.

The conductor 2 formed on the transparent substrate 1 is patterned into predetermined patterns by a photolithographic etching method. (Fig. 1(b)).

Then an organic film 3 (Fig. 1(c)) is formed on the conductor 2 by an electrolysis polymerization process. The electrolysis polymerization solution has to be an alkali hydroxide solution containing at least a monomer to be polymerized, or a basic alcohol solution containing alkali hydroxide. Further, a pH buffering solution and the like are added to the solution, if necessary. As the monomer, at least one of pyrrole, pyrrole derivative, phenol, and phenol derivative is used.

As the solvent, an alkali hydroxide solution containing alkali hydroxide such as NaOH, KOH, LiOH, or, a basic alcohol solution containing alkali hydroxide is used. A sufficient pH value of the alkali solution is 10 or more, a value of 10 through 13 is especially desirable.

An electrolysis method to polymerize the organic substance includes a potential scanning electrolysis method, a constant potential electrolysis method, a constant current electrolysis method, and an alternating current electrolysis method. As to the invention there is no limitation with respect the electrolysis method.

By the electrolysis polymerization with the aforementioned conditions appropriately combined, an electrochemically inactive film can be formed without requiring an electrochemical undoping.

On the organic insulating substance thus obtained, a metal film 4 of a prescribed pattern, such as Au, Ag, Cu, Pt, Ni, Co, Cr, Fe, Ta, Ti, or metallic oxide, e.g. $SnO_2$, $In_2O_3$, ZnO, CdO---metallic oxide, ZnS, CdS---metallic sulfide, a compound $CdSnO_4$ etc-based is formed by means of sputtering, vacuum deposition, CVD, etc (Fig. 1(d)). Thereby a non-linear resistor switching element with a conductor/insulator/conductor structure (two-terminal element) is formed.

This invention will now be explained further in detail with reference to working examples.

## Example 1

An ITO (Indium Tin Oxide) film 2 of a thickness of 150 nm is formed on a glass substrate 1 by a sputtering method. On the ITO film, a circular pattern of a diameter of 50 $\mu$m is formed.

As an electrolytic polymerization solution, a solution containing
    0.05 mol/l of 2.6-dimethylphenol
    0.05 mol/l of sodium hydroxide
is prepared. As a counter electrode, a platinum plate is used, and as a reference electrode, a silver oxide electrode is used. The above-mentioned glass substrate with ITO film formed thereon is immersed in the solution, and then an electrolysis polymerization reaction is carried out for 30 minutes at a constant potential of +1.6V. Thus, a polymethyl phenol film 3 of a thickness of about 200 nm is formed. After that, the film is washed with $H_2O$ and ethanol before being dried gently with Ar gas. Subsequently, another ITO film 4 of a thickness of 50 nm is formed by sputtering to complete a non-linear resistor switching element. The evaluation result of the I-V characteristic of the element shows that a switching characteristic for an adequate and stable switching is obtained without an undoping treatment.

## Example 2

An ITO film 2 of a thickness of 150 nm is formed on a glass substrate 1 by a sputtering method. On the ITO film, a pattern of a diameter of 50 $\mu$m is formed.

As an electrolytic polymerization solution, a solution containing
    0.25 mol/l of pyrrole and
    0.05 mol/l of potassium hydroxide
is prepared. As a counter electrode, a platinum plate is used, and as a reference electrode, a silver oxide electrode is used. The above-mentioned glass substrate with the ITO formed thereon is immersed in the electrolytic solution, and then an electrolytic polymerization reaction is carried out for 30 minutes at a constant potential of +1.4V. Thus, a polypyrrole film 3 of a thickness of about 200 nm is formed. After that, the film is washed with $H_2O$ and ethanol before being dried gently with Ar gas. Subsequently, another ITO film 4 of a thickness of 50 nm is formed by sputtering to complete a non-linear resistor switching element.

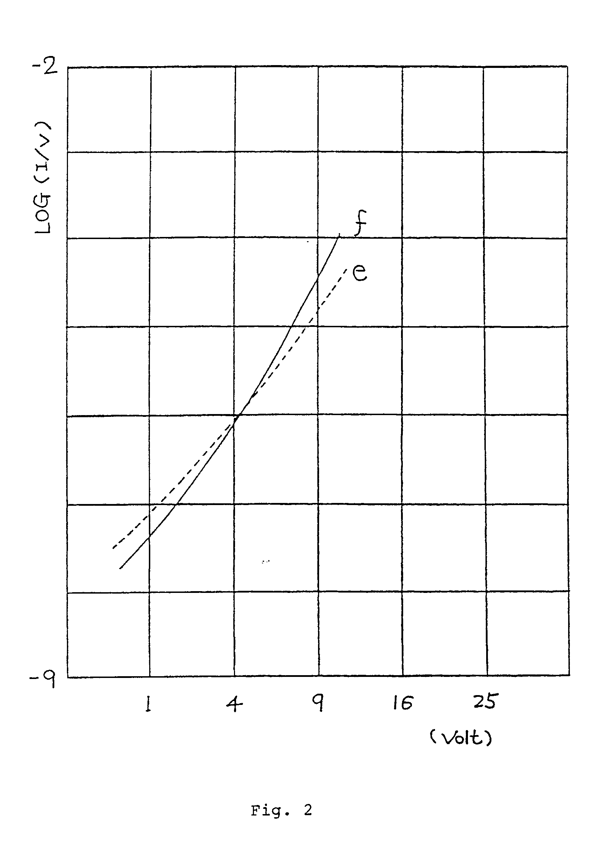

The evaluation result of the I-V characteristic of the element shows that a non-linear characteristic for an adequate and stable switching is obtained without undoping treatment. The above-mentioned characteristic is shown in Fig. 2. In Fig. 2, the abscissa shows the applied voltage and the ordinate shows the logarithmic value of conductance (inverse of resistance value). The characteristic corresponding to the case that the lower side conductor has a negative polarity is denoted e, whereas f is the characteristic for the case that the lower side conductor has a positive polarity. As shown in Fig. 2, the characteristic of the switching element mentioned in the example is, that the conductivity rises non-linearly as the voltage is increased. In other words, it is found that the switching element has efficient switching performance because its resistance value changes by at least a three-digit number depending on whether the applied voltage is high or low, and the characteristic shows little polarity dependency.

Example 3

An ITO film 2 of a thickness of 150 nm is formed on a glass substrate 1 by a sputtering method. On the ITO film, a pattern of a diameter of 50 $\mu$m is formed.

As an electrolytic polymerization solution, a solution containing

0.25 mol/l of pyrrcle
0.05 mol/l sodium hydroxide

is prepared. As a counter electrode, a platinum plate is used, and as a reference electrode, a silver-silver chloride electrode is used. The above-mentioned glass plate with the ITO thereon is immersed in the solution, and then an electrolysis polymerization reaction is carried out for 30 minutes at a constant potential of +1.3V. Thus, a polypyrrole film 3 of a thickness of about 200 nm is formed. After that, the film is washed with $H_2O$ and ethanol before being dried gently with Ar gas. Subsequently, another ITO film 4 of a thickness of 50 nm is formed by sputtering to form a non-linear resistor switching element. The evaluation result of the I-V characteristic of this element shows that a switching characteristic for an adequate and stable switching is obtained without undoping treatment.

Example 4

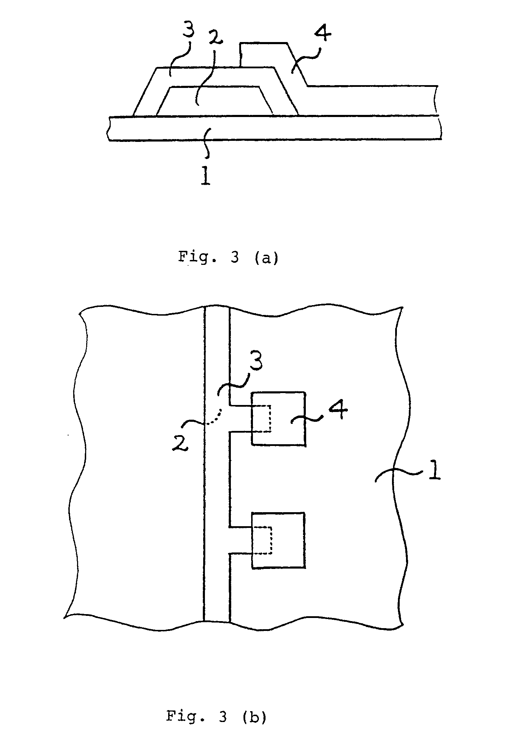

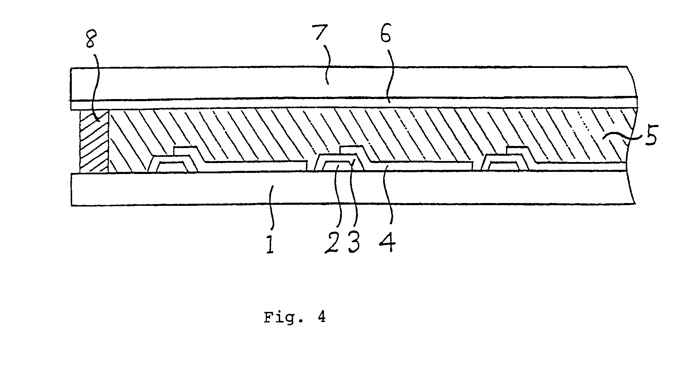

An ITO film 2 is formed on a first glass substrate 1 by a sputtering method, and patterned into plural columns of electrodes. Subsequently, the electrolytic polymer film 3 comprising polypyrrole is formed on the ITO column electrodes in a manner similar to Example 2. After that, another ITO film 4 of a thickness of 50 nm is formed on the whole surface of the glass substrate by a sputtering method. The ITO film 4 is patterned into an element shape as shown in Fig. 3 by a photolithographic etching method to form non-linear resistor switching elements of an ITO/Polypyrrole/ITO structure at prescribed places on the plural electrode columns. Each switching element (laminated structure part) is 25 $\mu$m x 15 $\mu$m in area. As opposite second substrate, a glass substrate 7 having plural ITO electrodes 6 (Fig. 4) is prepared, and stuck on the first substrate by a usual manufacturing process for a liquid crystal panel. Thus, an active matrix liquid crystal panel is prepared. The structure of the panel is shown in Fig. 4 where 8 designates a sealant. The area of each picture element is 200 $\mu$m x 200 $\mu$m at this stage. The liquid crystal panel is driven using the same driving circuit as a conventional MIM panel having the same area of the picture element and a MIM element which is 5 $\mu$m x 4 $\mu$m in area. The result of measuring the contrast shows that the panel is improved in contrast as compared with the conventional MIM panel. A great advantage is that the area of each switching element can be set larger than in the conventional case retaining the good switching performance, whereby the preparation of the element is facilitated.

Example 5

In Example 5, an electrolytic polymer film comprising polypyrrole is formed on the plural electrode columns patterned on the glass substrate in a manner similar to Example 3. Now, an active matrix liquid crystal panel is produced by the above mentioned procedure, and compared with the conventional panel. As a result, it is found that the contrast of the active matrix liquid crystal panel is superior to that of the conventional panel.

**Claims**

1. A non-linear resistor switching element comprising on a substrate (1) a first conductor (2), on the first conductor an insulator (3) and on the insulator a second conductor (4), wherein the insulator (3) is a highly insulating organic electrolytic polymer film formed by means of an electrolytic polymerization process on said electrode.

2. The switching element as claimed in claim 1, characterized in that the insulator (3) is an organic substance which is electrolytically polymerized in alkali hydroxide or basic alcohol containing alkali hydroxide.

3. The switching element as claimed in claim 1, characterized in that the insulator (3) is an electrolytic polymer containing at least one of pyrrole and a pyrrole derivative.

4. The switching element as claimed in claim 1, characterized in that the insulator (3) is an electrolytic polymer containing at least one of phenol and a phenol derivative.

5. An active matrix liquid crystal panel, comprising on a first transparent substrate (1) electrodes (2) in a prescribed pattern and a plurality of switching elements according to any of claims 1 to 5, wherein the electrodes form said first conductor of respective switching elements, and a second transparent substrate (7) which is sealingly fixed to said first substrate (1) and carries transparent electrodes (6) in a prescribed pattern, or a transparent substrate with a color filter.

6. A method for manufacturing a non-linear resistor switching element having a conductor/insulator/conductor structure, wherein the insulator is formed on a highly conductive material formed on a substrate as a first conductor and a second conductor of the same or a different material than said first conductor is formed on the insulator, and wherein the insulator is formed as a highly insulating organic electrolytic polymer film by an organic material which is electrolytically polymerized in an alkali hydroxide solution, or a basic alcohol solution containing alkali hydroxide as an supporting electrolyte.

7. The method according to claim 6, wherein at least one of pyrrole and a pyrrole derivative is used as organic substance to be electrolytically polymerized.

8. The method according to claim 6, wherein at least one of phenol and a phenol derivative is used as an organic substance to be electrolytically polymerized.

Fig. 1 (a)

Fig. 1 (b)

Fig. 1 (c)

Fig. 1 (d)

Fig. 2

Fig. 3 (a)

Fig. 3 (b)

Fig. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,P,X | EP-A-0 381 927   (SEIKO EPSON CORPORATION)<br>* the whole document *<br>— — — | 1-8 | H 01 L 45/00<br>C 09 D 5/44<br>G 02 F 1/136 |
| X | PATENT ABSTRACTS OF JAPAN vol. 10, no. 16 (E-375) 22 January 1986,<br>& JP-A-60 178669 (MITSUBISHI DENKI KK) 12 September 1985,<br>* the whole document *<br>— — — | 1,4 | |
| X | PATENT ABSTRACTS OF JAPAN vol. 10, no. 367 (E-462) 09 December 1986,<br>& JP-A-61 163659 (MITSUBISHI ELECTRIC CORP) 24 July 1986,<br>* the whole document *<br>— — — — — | 1,3 | |

TECHNICAL FIELDS
SEARCHED (Int. Cl.5)

H 01 L
C 09 D

The present search report has been drawn up for all claims

| Place of search | Date of completion of search | Examiner |
|---|---|---|
| The Hague | 02 July 91 | PELSERS L. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document